(19) Europäisches Patentamt / European Patent Office / Office européen des brevets

(11) **EP 2 312 327 B1**

(12) **FASCICULE DE BREVET EUROPEEN**

(45) Date de publication et mention de la délivrance du brevet:
**31.12.2014 Bulletin 2015/01**

(51) Int Cl.:
**B60L 3/12** *(2006.01)*    **G01R 31/00** *(2006.01)*
**G01R 19/00** *(2006.01)*

(21) Numéro de dépôt: **10187727.2**

(22) Date de dépôt: **15.10.2010**

(54) **Procédé et dispositif de mesure du courant électrique fourni par une ligne haute tension à un véhicule ferroviaire**

Vorrichtung und Verfahren zum Messen des über eine Hochspannungsleitung an ein Schienenfahrzeug gelieferten Stroms

Method and device for measuring the electric current supplied by a high-voltage line to a railway vehicle

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.10.2009 FR 0904953**

(43) Date de publication de la demande:
**20.04.2011 Bulletin 2011/16**

(73) Titulaire: **MS Relais**
**93118 Rosny sous Bois (FR)**

(72) Inventeurs:
• **Lejeune, Claude**
**72200 LA FLECHE (FR)**
• **Girard, Arnaud**
**53290 SAINT DENIS D'ANJOU (FR)**

(74) Mandataire: **Lavialle, Bruno François Stéphane et al**
**Cabinet Boettcher**
**16, rue Médéric**
**75017 Paris (FR)**

(56) Documents cités:
**EP-A2- 1 564 064    EP-A2- 1 947 465**
**US-A- 4 904 996**

EP 2 312 327 B1

## Description

La présente invention concerne un procédé et un dispositif de mesure du courant électrique fourni par une ligne haute tension à un véhicule ferroviaire.

## ARRIERE PLAN DE L'INVENTION

Différentes compagnies de transport peuvent désormais, suite à l'ouverture du marché ferroviaire à la concurrence, faire circuler des trains sur un même réseau ferroviaire. Par ailleurs, sur un même réseau ferroviaire peuvent également opérer plusieurs fournisseurs d'énergie.

Pour pouvoir facturer la consommation de chaque compagnie de transport, il est par conséquent nécessaire de mesurer de façon fiable et précise la consommation de chaque véhicule ferroviaire sur son parcours.

A cet effet on équipe les véhicules ferroviaires de dispositif permettant de compter l'énergie fournie à la locomotive.

On connaît à cet effet un premier dispositif de mesure utilisant un capteur à effet Hall, ce dispositif n'est toutefois pas satisfaisant, car il ne permet pas une bonne précision de la mesure du courant sur toute la plage de fonctionnement du dispositif compte tenu de non-linéarités, de l'offset et de phénomènes d'hystérésis. De ce fait, ce premier dispositif de mesure ne pourra satisfaire à la norme EN50463 prochainement applicable.

On connaît également du document EP1882954, déposé par la demanderesse, un second dispositif de mesure basé sur une technique de mesure connue sur les lignes de haute tension à savoir un shunt de mesure de courant.

Cette technique qui permet une mesure fiable et précise pose toutefois de nombreux inconvénients. Notamment, ce dispositif est volumineux et présente une masse importante. De plus, l'installation de ce dispositif sur un véhicule ferroviaire du parc existant est coûteuse et nécessite un temps de main d´oeuvre important, car il est nécessaire de démonter les barres d'origine.

Par ailleurs, le shunt fournit des tensions de l'ordre de 50 à 100mV, ce qui avec un courant de 2500A crée des pertes non négligeables, et un échauffement local important, même au courant nominal.

Le parc de véhicule ferroviaire étant très important, il y a un grand intérêt à proposer un dispositif de mesure dont la structure permet un temps de pose significativement plus court notamment inférieur à deux heures tout en assurant une mesure fiable et la conformité avec les normes en vigueur ou prochainement applicables telle que la norme EN50463.

On connaît par ailleurs du document EP1947465 un dispositif de mesure comportant des moyens de connexion à un tronçon d'un organe de captage du courant du véhicule, des moyens de détermination d'une différence de potentiel entre chacune des extrémités du tronçon, et des moyens de détermination du courant à partir d'une mesure de la différence de potentiel.

Ce dispositif n'est adaptable qu'a un organe de captage, ce qui limite fortement les possibilités d'adaptation aux différents véhicules et augmente sensiblement le temps nécessaire à son installation.

## OBJET DE L'INVENTION

La présente invention a pour objet de présenter un dispositif de mesure permettant de palier aux inconvénients des dispositifs de mesure décrits ci-dessus et notamment de proposer un dispositif de mesure dont l'installation sur le véhicule ferroviaire comporte un nombre restreint d'opérations d'usinage et de montage. La présente invention a également pour objet un procédé mettant en oeuvre ce dispositif de mesure.

## RESUME DE L'INVENTION

A cet effet, l'invention concerne un dispositif de mesure du courant électrique fourni par une ligne haute tension à un véhicule ferroviaire, caractérisé en ce qu'il comporte un organe de mesure haute tension comprenant des moyens de connexion aptes à connecter le dispositif en au moins deux points dits de jonction d'un bus de puissance du véhicule, des premiers moyens de mesure permettant la mesure d'une différence de potentiel entre les deux points de jonction du bus, des moyens de correction de la valeur mesurée, et des moyens d'estimation du courant à partir de la différence de potentiel.

Le dispositif peut être ainsi disposé sur un bus de puissance et non simplement sur l'organe de captage.

Selon l'invention, le procédé de mesure mettant en oeuvre le dispositif comprend, lors du montage du dispositif sur le bus de puissance, une étape de calibrage du dispositif de mesure.

## EP 2 312 327 B1

**BREVE DESCRIPTION DES DESSINS**

La présente invention sera mieux comprise à la lecture d'un exemple détaillé de réalisation en référence aux figures annexées, fournies à titre d'exemple non limitatif et telles que :

- la figure 1 représente de manière schématique un dispositif selon un premier mode de réalisation de l'invention, le dispositif étant connecté sur le bus de puissance d'un véhicule ferroviaire,
- la figure 2 est un graphique illustrant l'évolution de la résistivité du cuivre en fonction de la température,
- la figure 3 est un schéma d'un dispositif pour la mise en oeuvre du procédé de calibrage.
- la figure 4 est une vue en coupe d'un dispositif selon un deuxième mode de réalisation de l'invention conforme au schéma de la figure 1.

**DESCRIPTION DETAILLEE DE L'INVENTION**

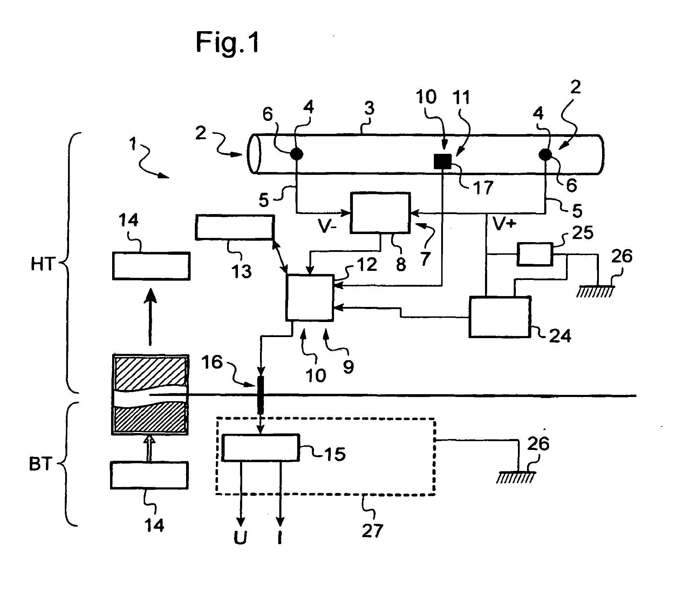

En se reportant principalement à la figure 1 on voit représenté un dispositif de mesure 1.

Ce dispositif 1 a pour fonction de venir mesurer le courant électrique fourni par une ligne haute tension à un véhicule ferroviaire et plus précisément à la locomotive ou aux motrices d'un train.

Ce dispositif de mesure 1 comporte à cet effet des moyens de connexion 2 permettant la connexion entre le dispositif 1 et le bus de puissance du véhicule 3. Ce bus de puissance 3 sera constitué dans le reste de la demande par une barre de cuivre. Un même véhicule peut contenir plusieurs bus de puissance indépendants ou reliés au même organe de captage.

Dans l'exemple de réalisation, la connexion s'effectue en deux points dits points de jonction 4. Toutefois, dans le cas où le dispositif de mesure 1 équipe un véhicule comportant plusieurs bus de puissance 3 et notamment deux barres de cuivre en parallèle du véhicule, on prévoit au niveau des moyens de connexion 2 quatre câbles à savoir deux câbles par barre de cuivre.

Selon un mode de réalisation avantageux de l'invention les moyens de connexion 2 comportent des moyens d'enserrement 6. Ces moyens d'enserrement 6 permettent une connexion sans avoir à réaliser d'usinage sur la barre de puissance 3. De manière avantageuse des moyens d'enserrement 6 comportent deux pinces chacune étant assujettie à une extrémité de chaque câble 5. Ces pinces viennent enserrer la barre de cuivre 3 et sont ainsi aisément positionnables sur la barre de cuivre 3. La connexion du dispositif de mesure 1 sur le bus de puissance 3 est alors assurée.

Ce mode de réalisation est particulièrement avantageux puisqu´il permet un montage et un démontage rapide des câbles 5 sur le bus de puissance 3.

Différents autres types de connexions à la portée de l'homme du métier sont cependant envisageables. A titre d'exemple, dans une première variante on réalise l'assemblage par boulonnage après avoir inséré l'extrémité de chaque câble 5 dans un percement ménagé dans le bus de puissance. Dans une seconde variante, on réalise la connexion du câble 5 en venant souder son extrémité à l'intérieur d'un percement ménagé dans le bus de puissance 3.

La distance entre les points de jonction 4 ne doit être trop courte afin d'avoir une tension suffisante pour assurer la précision de la mesure.

A cette fin on prévoit que l'écartement entre les deux points de jonction 4 sur le bus de puissance 3 est supérieur à 100 mm et de préférence de l'ordre de 200mm.

Le dispositif de mesure 1 comporte en outre des premier moyens de mesure 7, permettant la mesure d'une différence de potentiel entre les deux points de jonction du bus et comportant un convertisseur 8 de type CAN relié à des moyens de traitement 9.

Le dispositif de mesure 1 comporte également des moyens de correction 10 de la valeur mesurée. Ces moyens de correction 10 comportent d'une part des deuxièmes moyens de mesure 11 permettant la mesure de la température du bus de puissance 3 et d'autre part les moyens de traitement 9 reliés au convertisseur 8.

Ces moyens de traitement 9 comportent un processeur 12 associé à une mémoire non volatile 13.

Ces moyens de traitement 9 sont, en outre, associés à une alimentation 14 permettant son fonctionnement. Cette alimentation 14 en continu présente une isolation galvanique élevée entre son entrée et sa sortie.

Les moyens de traitement 9 comportent des moyens de transmission 16 de la valeur corrigée en direction d'une unité de traitement extérieure 15.

Avantageusement ces moyens de transmission 16 sont de type optique assurant un isolement galvanique entre le bus de puissance et le signal de sortie représentatif de la valeur corrigée.

En effet, le dispositif de mesure 1 mesure les hautes tensions provenant des caténaires et fait donc partie d'un circuit haute tension de la locomotive (HT).

Parallèlement au circuit haute tension, les installations usuelles du train, telles l'éclairage ou les commandes, sont alimentées par un circuit basse tension (BT), indépendant du circuit haute tension.

Ainsi, l'unité de traitement extérieure 15 fait partie du circuit basse tension alors que les premiers moyens de

3

mesure 7 font partie du circuit haute tension.

Or, les circuits haute tension et basse tension doivent être isolés électriquement l'un de l'autre pour faire face à des événements critiques tels que la rupture de caténaires. Lors d'une rupture de caténaire, celle-ci peut tomber sur le toit du train où est généralement disposé le dispositif de mesure. Il est alors nécessaire d'éviter que le caténaire puisse entrer en contact avec le circuit basse tension et n'alimente le circuit basse tension avec de la haute tension.

L'utilisation de la liaison optique 16 entre les moyens de traitement 9 et l'unité de traitement extérieure 15 permet de ne pas recourir à une liaison électrique telle qu'un câble métallique conducteur. La liaison optique participe ainsi à l'isolation électrique entre les circuits haute tension et basse tension.

De plus, l'unité de traitement extérieure 15 est enveloppée par un blindage métallique 27 relié à la masse 26 du véhicule. Ainsi, si la caténaire venait en contact avec l'unité de traitement extérieure 15, le courant serait dirigé vers la masse, empêchant la transmission de la haute tension dans le circuit basse tension.

Les deuxièmes moyens de mesure de la température 11 permettent de corriger la mesure du potentiel en fonction de la dérive ohmique du matériau du bus de puissance avec une variation de la température.

En effet, la mesure de la différence de potentiel sur le bus de puissance 3, constitué par la barre de cuivre, doit tenir compte du fait que la résistivité du cuivre évolue fortement dans la gamme de température - 40°C/+150°C et rend nécessaire une compensation en fonction de la température du bus de puissance.

Il faut cependant noter que sur la gamme de température précitée, l'évolution de la résistivité du cuivre est sensiblement linéaire, de sorte qu'une approximation linéaire permet d'obtenir une valeur précise de la résistivité de la barre en fonction de la variation de température.

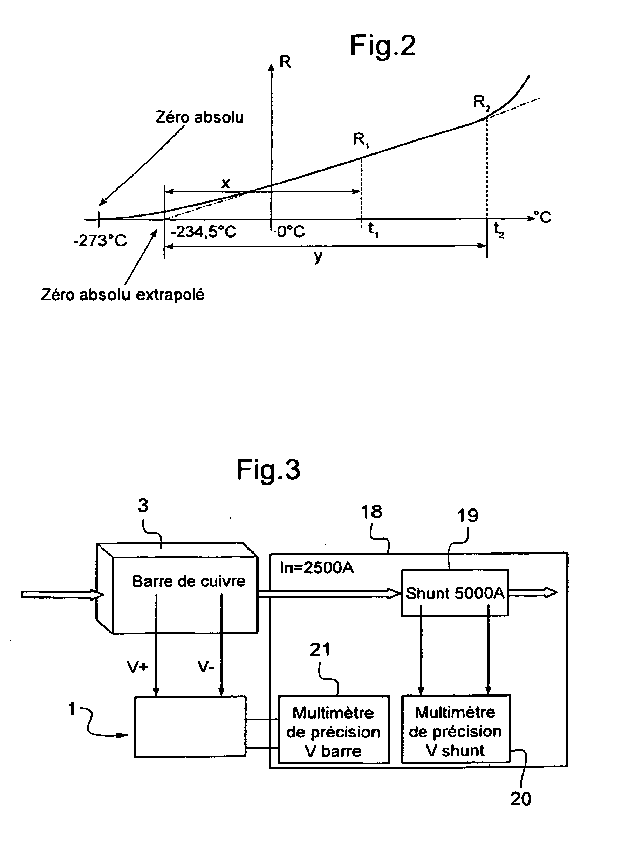

A ce sujet, un graphique montrant la variation de la résistivité en fonction de la variation de température est représenté en figure 2.

Le paramètre température va varier lors des différentes prises de mesure et doit donc être pris en compte et faire l'objet d'une compensation en permanence.

A cette fin les moyens de mesure de la température 11 sont avantageusement réalisés par un capteur de température 17 de type circuit intégré. Ce type de capteur peut présenter des résolutions de 0.07°C au mieux. En termes de résolution cela est suffisant, car une évolution de 1°C donne une mesure de tension supérieure de 0.4% pour le même courant, donc pour 0.07°C seulement 0.028%, bien inférieur au 1% recherché.

La demanderesse a également établi lors de tests que la fonction de compensation suivante permettait d'obtenir une compensation adéquate des valeurs de tension mesurées par les moyens de mesure :

$$\rho(\theta) = \rho(20°C) * \left(1 + K * (\theta - 20°C)\right)$$

Avec :

$\theta$ : température de la barre en °C

$\rho$ : résistivité en $\Omega.m$

K : coefficient de température

Cela étant, d'autres paramètres de dispersion de la mesure dépendent des caractéristiques du montage ou des composants utilisés ou encore de la géométrie du bus de puissance et doivent être calculés pour pouvoir être compensés.

Ces paramètres sont principalement la variation de côte de la section et de l'entraxe du bus de puissance au niveau des points de jonction, l'écart entre les points de jonction, la variation de la composition chimique de la barre ou encore la dérive du convertisseur analogique.

Ces paramètres ne varient pas toutefois lors du fonctionnement du dispositif de mesure 1 et peuvent par conséquent être calibrés par des moyens de calibration une fois le montage réalisé. Le calibrage, une fois réalisé, permet le calcul de la dispersion lors du fonctionnement du dispositif de mesure 1 pour une température donnée.

En effet, la résistance entre les points de jonction 4 suit la formule suivante :

$$R(\theta) = \rho(20°C) * (1 + K * (\theta - 20°C)) * \frac{L}{S}$$

Avec :

L : longueur entre les points de mesure en mètres

S : section de cuivre en m$^2$

Étant donné que cette équation est linéaire ($\theta$ est la seule variable), elle peut s'écrire sous la forme

$$R(\theta) = a * \theta + b$$

En développant l'équation R($\theta$) on obtient a et b :

$$R(\theta) = \rho(20°C) * (1 + K\theta - 20 * K) * \frac{L}{S}$$

$$R(\theta) = \frac{\rho(20°C) * L + K * \theta * \rho(20°C) * L - 20 * K * \rho(20°C) * L}{S}$$

Donc on a pour a et b :

$$a = \frac{K * \rho(20°C) * L}{S}$$

$$b = \frac{\rho(20°C) * L - 20 * K * \rho(20°C) * L}{S}$$

Le capteur de température 17 comprend lui aussi une erreur de gain et d'offset qui suit l'équation suivante :

$$\theta mesuré = G * \theta réel + offset$$

Avec :

G : erreur de gain, sur toute la plage de mesure
Offset : décalage de niveau, sur toute la plage de mesure

Étant donné que cette équation est linéaire ($\theta$ est la seule variable), elle peut s'écrire sous la forme

$$\theta mesuré = c * \theta réel + d$$

Avec :

c = G
Et
d = offset

En résumé, les dispersions subies sont les suivantes :

$$R(\theta r\acute{e}el) = a * \theta r\acute{e}el + b \qquad (1)$$

et

$$\theta mesur\acute{e} = c * \theta r\acute{e}el + d \qquad (2)$$

(2) peut s'écrire aussi sous la forme de :

$$\theta r\acute{e}el = \frac{\theta mesur\acute{e} - d}{c} \qquad (3)$$

Donc en intégrant (3) dans (1) on obtient :

$$R(\theta mesur\acute{e}) = \frac{a * (\theta mesur\acute{e} - d)}{c} + b$$

Donc

$$R(\theta mesur\acute{e}) = \frac{a}{c} * \theta mesur\acute{e} - \frac{a * d}{c} + b$$

Cette équation peut aussi s'écrire sous la forme :

$$R(\theta mesur\acute{e}) = A * \theta mesur\acute{e} + B$$

Où :

$$A = \frac{a}{c}$$

et

$$B = -\frac{a * d}{c} + b$$

Si l'on développe A et B cela donne :

$$A = \frac{K * \rho(20°C) * L}{G * S}$$

Et

$$B = \frac{K * \rho(20°C) * L * offset}{G * S} + \frac{\rho(20°C) * (1 - 20 * K) * L}{S}$$

On peut par conséquent une fois les inconnues A et B calibrées compenser de manière précise les déviations pour une température donnée.

De plus, il n'est pas nécessaire de calibrer individuellement les différents paramètres $\rho(20°C)$, L, S, offset, G et K pour compenser la mesure en température, seule la détermination des inconnues A et B est nécessaire.

En se reportant à la figure 3 on voit représenté un exemple de réalisation d'un dispositif de calibrage 18 permettant la détermination des paramètres A et B propres à l'ensemble constitué du dispositif de mesure 1 et du bus de puissance 3. Ce dispositif de calibrage 18 permet de réaliser l'étape de calibrage du procédé de mesure.

Selon l'exemple avantageux de réalisation illustré à la figure 3, le dispositif de calibrage 18 comprend un shunt de précision 19 d'un calibre plus élevé que l'intensité du courant injecté dans le bus de puissance In pour ne pas échauffer le shunt. Par exemple, une résistance de shunt de l'ordre de 5000A pour un courant injecté de 2500 A.

Le dispositif de calibrage 18 comporte en outre un premier multimètre de précision 20 associé au shunt pour déduire le courant circulant dans le circuit (Vshunt) et un second multimètre de précision 21 pour mesurer la tension entre les bornes de mesure distantes de L (Vbarre).

L'étape de calibrage consiste à mesurer au moins un courant injecté dans le bus de puissance 3 entre les points de jonction 4 à l'aide du second multimètre 21 et à la comparer à une mesure de shunt.

A titre d'exemple, on pourra injecter, pour réaliser le calibrage, des courants représentant 4, 10, 100 et 120% du courant nominal et effectuer des mesures avant et après stabilisation.

D'autres modes de réalisation du dispositif de calibrage 18 peuvent également être envisagés et notamment le shunt de précision 19 peut dans une variante être remplacé par un autre dispositif de mesure.

Le calibrage consiste ainsi à injecter au moins un courant dans le bus de puissance 3, à mesurer la tension entre les points de jonction 4 et à la comparer à une mesure obtenue en parallèle par le dispositif de calibrage 18. La tension lue sur la barre de cuivre sera :

$$Vbarre = \frac{R(\theta mesuré) * Vshunt}{Rshunt}$$

Ce qui donne :

$$R(\theta mesuré) = \frac{Vbarre * Rshunt}{Vshunt}$$

Rappelons nous que :

$$R(\theta mesuré) = A * \theta mesuré + B$$

On a donc :

$$A * \theta mesuré + B = \frac{Vbarre * Rshunt}{Vshunt}$$

Les valeurs de Vbarre, Rshunt et Vshunt étant connues pour deux valeurs de $\theta$ mesurées, on peut en déduire les coefficients A et B propres à l'installation. Les moyens de traitement 9 sont ensuite programmés en fonction des valeurs obtenues pour A et B.

Le dispositif de mesure 1 peut donc être monté sur des bus de puissance 3 et être calibré de manière fiable indépendamment de la géométrie du bus de puissance 3 et du montage des points de jonction 4.

Le dispositif de mesure 1 est opérationnel une fois calibré. Le fonctionnement du dispositif de mesure 1 consiste alors à réaliser à la fois des mesures de différence de potentiel entre les deux points de jonction et des mesures de température, puis à compenser la valeur mesurée en fonction des paramètres A et B et de la température.

La valeur compensée est ensuite transmise en direction de l'unité de traitement extérieure 15.

Le procédé de mesure selon l'invention comporte en plus de l'étape de calibrage, une étape de mesure de la différence de potentiel, une étape de correction de la valeur obtenue par l'étape de mesure et une étape de transmission de la valeur corrigée.

Compte tenu des impératifs des normes en vigueur, la mesure de différence de potentiel entre les deux points de jonction 4 sera réalisée en continu.

Le dispositif de mesure 1 décrit ci-dessus permet par conséquent de mesurer avec précision et en temps réel le courant consommé par le véhicule ferroviaire.

Le dispositif de mesure 1 peut également mesurer avec précision une tension prise entre un point de jonction 4 et la masse 26. A cet effet et comme illustré en figure 1, le dispositif de mesure 1 comporte des troisièmes moyens de mesure 24 mesurant la tension aux bornes d'une résistance 25 disposée entre la jonction 4 et la masse 26.

La mesure de tension est alors corrigée par les moyens de correction 10 selon le procédé décrit précédemment.

Ainsi, il est possible d'obtenir la tension et l'intensité circulant dans le bus de puissance 3 à chaque instant, avec un seul appareil. En multipliant en temps réel ces deux grandeurs et en intégrant le résultat, il est aisé d'en déduire la puissance consommée.

L'estimation de la puissance consommée par le véhicule est donc facilement réalisable par un seul dispositif.

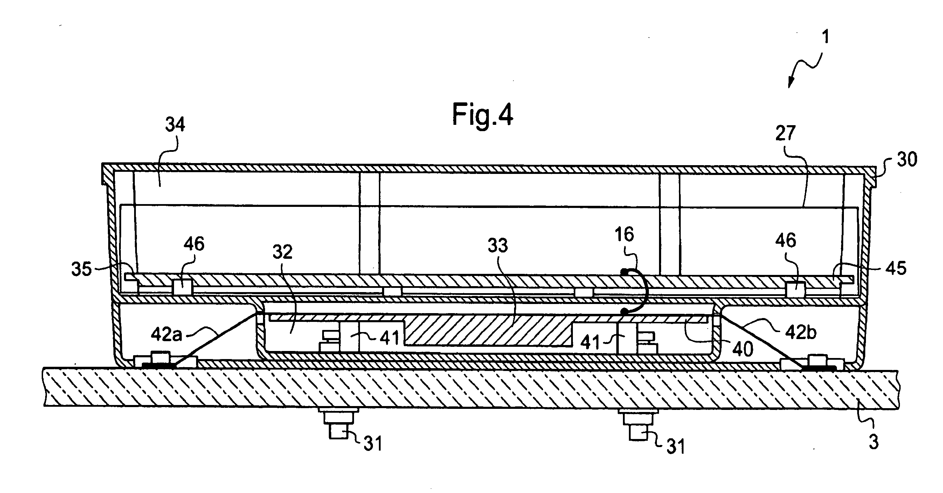

Ce dispositif de mesure 1 est par ailleurs relativement aisé à installer par rapport aux dispositifs antérieurs puisqu'il ne nécessite pas le démontage des barres de cuivre comme l'illustre en particulier la figure 4.

Le dispositif 1 comporte un boîtier 30 en plastique fixé directement sur le bus de puissance 3, ici une barre de section rectangulaire, par des vis 31. Le boîtier 30 comprend un premier compartiment 32 dans lequel est disposé le circuit haute tension 33 du dispositif et un deuxième compartiment 34, indépendant et isolé électriquement du premier compartiment 32, dans lequel est disposé le circuit basse tension 35 du dispositif. Le boîtier 30 est agencé de sorte à permettre un accès aisé aux différents compartiments et éléments constitutifs du dispositif.

Les composants électroniques (moyens de mesure 7, mémoire volatile 13...) sont fixés sur une première plaque support 40, elle-même fixée dans le premier compartiment 32 grâce à des plots 41.

Le dispositif 1 comporte également des moyens de connexion 2, ici deux pattes de connexion 42a et 42b reliant la première plaque support 40 au bus de puissance 3. Les pattes de connexion 42a et 42b sont fixées par une extrémité sur le bus de puissance 3 et par une autre extrémité sont reliées aux moyens de mesure 7 fixés sur la première plaque support 40.

Les pattes de connexion 42a et 42b sont particulièrement avantageuses dans ce mode de réalisation car le bus de puissance est une barre de section rectangulaire et donc sensiblement moins adaptée à des pinces. De plus, l'utilisation de pattes de connexion permet d'avoir un écart constant entre les points de jonction 4, de sorte que la calibration du dispositif 1 est plus simple.

L'unité de traitement extérieure 15 est fixée sur une deuxième plaque support 45, elle-même fixée dans le deuxième compartiment 34 grâce à des plots 46. La deuxième plaque support 45 et l'unité de traitement extérieure 15 sont entourées d'un blindage métallique 27 relié à la masse du véhicule (non représentée).

Une liaison optique 16, ici simplement schématisée, relie le circuit basse tension et le circuit haute tension.

Ainsi, les deux circuits 33, 35 sont isolés physiquement l'un de l'autre dans des compartiments indépendants 32, 34. Le seul lien reliant ces circuits est un lien optique 16, qui ne peut donc conduire l'électricité. De plus, le circuit basse tension 35 est entouré d'un blindage métallique 27 qui permet de diriger le courant haute tension vers la masse dans le cas où ledit circuit basse tension entrerait en contact avec une source haute tension.

Le dispositif se présente donc sous la forme d'un boîtier 30 qui peut se fixer simplement et directement en n'importe quelle position du bus de puissance grâce à des vis ou à des moyens d'enserrement. Il n'est donc pas nécessaire d'installer le dispositif sur l'organe de captage du courant, ce qui confère à l'invention une grande souplesse d'utilisation.

De plus, le dispositif permet d'estimer la puissance consommée sur un bus de puissance sans avoir recours à un second appareil de mesure de la tension du bus par rapport à la masse. Plusieurs dispositifs peuvent être disposés dans le véhicule lorsque plusieurs bus de puissance coexistent.

D'autres caractéristiques de l'invention auraient également pu être envisagées sans pour autant sortir du cadre de l'invention définie par les revendications ci-après.

**Revendications**

1.  Dispositif de mesure du courant électrique fourni par une ligne haute tension à un véhicule ferroviaire, **caractérisé en ce qu'**il comporte un organe de mesure haute tension comprenant des moyens de connexion (2) aptes à connecter le dispositif en au moins deux points dits de jonction (4) d'un bus de puissance (3) du véhicule, des premiers moyens de mesure (7) permettant la mesure d'une différence de potentiel entre les deux points de jonction du bus, des moyens de correction (10) de la valeur mesurée, et des moyens d'estimation du courant (9, 10) à partir de la différence de potentiel.

2.  Dispositif de mesure selon la revendication 1 dans lequel les premiers moyens de mesure (7) comportent des moyens de mesure de l'intensité.

3.  Dispositif de mesure selon l'une quelconque des revendications précédentes, comportant des troisièmes moyens de mesure (25) de la tension entre un des points de jonction (4) et la masse, et des moyens de correction (10) de la valeur mesurée.

4.  Dispositif de mesure selon l'une quelconque des revendications précédentes, dans lequel les moyens de correction (10) comportent des moyens de traitement (9) associés à des deuxièmes moyens de mesure de la température (11) permettant de corriger la mesure du potentiel en fonction de la dérive ohmique du matériau du bus de puissance avec une variation de la température.

5.  Dispositif de mesure selon la revendication 4 dans lequel les deuxièmes moyens de mesure (11) comportent un capteur de température (17) de type circuit intégré.

6.  Dispositif de mesure selon l'une quelconque des revendications précédentes dans lequel les moyens de correction (10) de la valeur mesurée permettent en outre une compensation en fonction des caractéristiques des différents éléments de l'ensemble formé par le dispositif de montage et le bus de puissance (3).

7.  Dispositif de mesure selon l'une quelconque des revendications précédentes comportant un circuit haute tension (HT) comprenant les moyens de connexion (2), les premiers moyens de mesure (7) et les moyens de correction (10), et un circuit basse tension (BT), comprenant une unité de traitement extérieur (15), le circuit basse tension (BT) et le circuit haute tension (HT) étant isolés électriquement entre eux, et des moyens de transmission (16) pour transférer la valeur corrigée depuis le circuit haute tension (HT) vers le circuit basse tension (BT) sans transmission de courant électrique.

8.  Dispositif de mesure selon la revendication 7 dans lequel les moyens de transmission (16) de la valeur corrigée sont de type optique assurant un isolement galvanique entre le circuit haute tension (HT) et le circuit basse tension (BT).

9.  Dispositif de mesure selon la revendication 7 dans lequel le circuit basse tension (BT) est enveloppé par un blindage métallique (27) relié à la masse (26).

10. Dispositif de mesure selon l'une quelconque des revendications précédentes dans lequel l'écartement entre les deux points de jonction (4) sur le bus de puissance (3) est supérieur à 100 mm et de préférence de l'ordre de 200mm.

11. Dispositif de mesure selon l'une quelconque des revendications précédentes dans lequel les moyens de connexion (2) comportent des moyens d'enserrement (6) aptes à enserrer le bus de puissance (3) et permettant la réalisation des points de jonction (4) et la connexion du dispositif de mesure sur le bus de puissance (3).

12. Dispositif de mesure selon la revendication 9 dans lequel les moyens de connexion (2) comportent des pattes de connexion (42a, 42b) aptes à être fixées par vissage sur le bus de puissance (3).

13. Procédé de mesure mis en oeuvre dans un dispositif selon l'une quelconque des revendications précédentes dans lequel on réalise lors du montage du dispositif sur le bus de puissance (3) une étape de calibrage du dispositif de mesure.

14. Procédé de mesure selon la revendication 13 dans lequel l'étape de calibrage consiste à injecter au moins un courant dans le bus de puissance (3), à mesurer la tension entre les points de jonction (4) et à la comparer à une mesure obtenue en parallèle par un dispositif de calibrage (18).

15. Procédé de mesure selon la revendication 13 dans lequel le procédé comporte une étape de mesure de la différence de potentielle, une étape de correction de la valeur obtenue par l'étape de mesure et une étape de transmission de la valeur corrigée.

16. Procédé de mesure selon la revendication 13 dans laquelle la mesure de différence de potentiel est réalisée en continu.

**Patentansprüche**

1. Vorrichtung zum Messen des elektrischen Stroms, der von einer Hochspannungsleitung an ein Schienenfahrzeug geliefert wird, **dadurch gekennzeichnet, dass** sie ein Hochspannungsmessorgan umfasst, das Anschlussmittel (2) enthält, die dazu geeignet sind, die Vorrichtung an mindestens zwei sogenannten Anschlusspunkten (4) einer Sammelschiene (3) des Fahrzeugs anzuschließen, erste Messmittel (7), die das Messen einer Potentialdifferenz zwischen den beiden Anschlusspunkten der Schiene ermöglichen, Korrekturmittel (10) zum Korrigieren des Messwertes sowie Schätzmittel (9, 10) zum Schätzen des Stroms ausgehend von der Potentialdifferenz.

2. Messvorrichtung nach Anspruch 1, wobei die ersten Messmittel (7) Mittel zum Messen der Intensität umfassen.

3. Messvorrichtung nach einem der vorhergehenden Ansprüche, umfassend dritte Messmittel (25) zum Messen der Spannung zwischen einem der Anschlusspunkte (4) und der Masse und Korrekturmittel (10) zum Korrigieren des Messwertes.

4. Messvorrichtung nach einem der vorhergehenden Ansprüche, wobei die Korrekturmittel (10) Verarbeitungsmittel (9) umfassen, die mit zweiten Messmitteln (11) zum Messen der Temperatur verbunden sind, die ein Korrigieren der Messung des Potentials in Abhängigkeit von der ohmschen Drift des Materials der Sammelschiene mit einer Veränderung der Temperatur ermöglichen.

5. Messvorrichtung nach Anspruch 4, wobei die zweiten Messmittel (11) einen Temperatursensor (17) nach Art eines integrierten Schaltkreises umfassen.

6. Messvorrichtung nach einem der vorhergehenden Ansprüche, wobei die Korrekturmittel (10) zum Korrigieren des Messwertes ferner einen Ausgleich in Abhängigkeit der Charakteristiken der verschiedenen Elemente der aus der Montagevorrichtung und der Sammelschiene (3) gebildeten Einheit ermöglichen.

7. Messvorrichtung nach einem der vorhergehenden Ansprüche, umfassend einen Hochspannungskreis (HT), der die Anschlussmittel (2), die ersten Messmittel (7) und die Korrekturmittel (10) umfasst, sowie einen Niederspannungskreis (BT), der eine äußere Verarbeitungseinheit (15) umfasst, wobei der Niederspannungskreis (BT) und der Hochspannungskreis (HT) zueinander elektrisch isoliert sind, und Übertragungsmittel (16) zum Übertragen des korrigierten Wertes von dem Hochspannungskreis (HT) zum Niederspannungskreis (BT) ohne eine Übertragung von elektrischem Strom.

8. Messvorrichtung nach Anspruch 7, wobei die Übertragungsmittel (16) zum Übertragen des korrigierten Wertes optischer Art sind, die eine galvanische Trennung zwischen dem Hochspannungskreis (HT) und dem Niederspannungskreis (BT) sicherstellen.

9. Messvorrichtung nach Anspruch 7, wobei der Niederspannungskreis (BT) von einer mit der Masse (26) verbundenen metallischen Abschirmung (27) umhüllt ist.

10. Messvorrichtung nach einem der vorhergehenden Ansprüche, wobei der Abstand zwischen den beiden Anschlusspunkten (4) auf der Sammelschiene (3) größer als 100 mm und vorzugsweise in der Größenordnung von 200 mm ist.

11. Messvorrichtung nach einem der vorgehenden Ansprüche, wobei die Anschlussmittel (2) Einspannmittel (6) umfassen, die dazu geeignet sind, die Sammelschiene (3) einzuspannen und die Realisierung der Anschlusspunkte (4) und den Anschluss der Messvorrichtung auf der Sammelschiene (3) ermöglichen.

**12.** Messvorrichtung nach Anspruch 9, wobei die Anschlussmittel (2) Anschlusslaschen (42a, 42b) umfassen, die dazu geeignet sind, auf der Sammelschiene (3) durch Verschraubung befestigt zu werden.

**13.** Messverfahren, angewandt bei einer Vorrichtung nach einem der vorhergehenden Ansprüche, wobei man während der Montage der Vorrichtung auf der Sammelschiene (3) einen Kalibrierschritt zum Kalibrieren der Messvorrichtung durchführt.

**14.** Messverfahren nach Anspruch 13, wobei der Kalibrierschritt darin besteht, dass mindestens ein Strom in die Sammelschiene (3) eingekoppelt, die Spannung zwischen den Anschlusspunkten (4) gemessen und mit einer Messung verglichen wird, die parallel von einer Kalibriervorrichtung (18) erhalten wird.

**15.** Messverfahren nach Anspruch 13, wobei das Verfahren einen Messschritt zum Messen der Potentialdifferenz, einen Korrekturschritt zum Korrigieren des durch den Messschritt erhaltenen Wertes und einen Übertragungsschritt zum Übertragen des korrigierten Wertes umfasst.

**16.** Messverfahren nach Anspruch 13, wobei die Potentialdifferenzmessung kontinuierlich erfolgt.


**Claims**

**1.** A device for measuring the electric current supplied to a rail vehicle by a high voltage line, **characterized in that** it comprises a high voltage measuring element comprising connection means (2) adapted to connect the device with at least two so-called junction points (4) of a power bus (3) of the vehicle, with first measuring means (7) making it possible to measure a potential difference between the two junction points of the bus, means for correcting (10) the measured value, and means for estimating (9, 10) the current from the potential difference.

**2.** A measuring device according to claim 1, wherein the first measuring means (7) comprise means for measuring the intensity.

**3.** A measuring device according to any one of the preceding claims, comprising third means for measuring (25) the voltage between one of the junction points (4) and the ground, and means for correcting (10) the measured value.

**4.** A measuring device according to any one of the preceding claims, wherein the correction means (10) comprise processing means (9) associated with second means for measuring the temperature (11) making it possible to correct the measure of the potential according to the ohmic drift of the material of the power bus with a variation of the temperature.

**5.** A measuring device according to claim 4, wherein the second measuring means (11) comprise a temperature sensor (17) of the integrated circuit type.

**6.** A measuring device according to any one of the preceding claims, wherein the means for correcting (10) the measured value can also be compensated based on the characteristics of the various elements of the assembly formed by the mounting device and the bus power (3).

**7.** A measuring device according to any one of the preceding claims, including a high voltage circuit (HT) comprising connection means (2), the first measuring means (7) and the correction means (10), and a low voltage circuit (TB), comprising an external processing unit (15), with the low voltage circuit (BT) and the high voltage circuit (HT) being electrically insulated from each other, and transmitting means (16) for transferring the corrected value from the high voltage circuit (HT) to the low voltage circuit (BT) without transmission of electric current.

**8.** A measuring device according to claim 7, wherein the means for transmitting (16) the corrected value are of the optical type providing a galvanic insulation between the high voltage circuit (HT) and the low voltage circuit (BT).

**9.** A measuring device according to claim 7, wherein the low voltage circuit (BT) is wrapped in a metallic shield (27) connected to the ground (26).

**10.** A measuring device according to any one of the preceding claims, wherein the spacing between the two junction points (4) on the power bus (3) is greater than 100mm and preferably of the order of 200mm.

11. A measuring device according to any one of the preceding claims, wherein the connection means (2) comprise enclosing means (6) adapted to enclose the power bus (3) and for providing the junction points (4) and the connection of the measuring device on the power bus (3).

12. A measuring device according to claim 9, wherein the connection means (2) comprise connecting pins (42a, 42b) adapted to be fixed by screwing on the power bus (3).

13. A method of measurement implemented in a device according to any one of the preceding claims, wherein a step of calibrating the measuring device is carried out when mounting the device on the power bus (3).

14. A method of measurement according to claim 13, wherein the step of calibration consists in injecting at least one current into the power bus (3), in measuring the voltage between the junction points (4) and in comparing it to a measure obtained in parallel by a calibration device (18).

15. A method of measurement according to claim 13, wherein the method comprises of step of measuring the potential difference, a step of correcting the value obtained by the measuring step and a step of transmitting the corrected value.

16. A method of measurement according to claim 13, wherein the measurement of potential difference is carried out continuously.

## Fig.1

# Fig.2

# Fig.3

# Fig.4

EP 2 312 327 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1882954 A
- EP 1947465 A